# EUROPEAN PATENT APPLICATION

(11) **EP 1 939 136 A2**
(43) Date of publication of application: **02.07.2008**
(21) Application number: 07300760.1
(22) Date of filing: 01.02.2007
(51) Int. Cl.: B81B 1/00

(54) **High throughput pressure resistant microfluidic devices**

(30) Priority: 29.12.2006 EP 06301311
(71) Applicant: Corning Incorporated, Corning, NY 14831 (US)
(72) Inventor: Hoysan, Steven F, HOUSTON TEXAS, 77095 (US); Lobet, Olivier, 91500, MENNECY (FR); Woehl, Pierre, 77240, CESSON (FR)
(74) Representative: Le Roux, Martine

(57) **Abstract**

A micro fluidic device, comprising wall structures formed of a consolidated frit material positioned between and joined to two or more spaced apart substrates formed of a second material with the wall structures defining one or more fluidic passages between the substrates, has at least one passage with a height in a direction generally perpendicular to the substrates of greater than one millimeter, preferably greater than 1.1 mm, or than 1.2 mm, or than as much as 1.5 mm or more, and may have a non- three-dimensionally tortuous portion of the at least one passage, in which the wall structures have an undulating shape such that no length of wall structure greater than 3 centimeters or greater than 2 centimeters, or greater than 1 centimeter, or even no length at all, is without a radius of curvature. A device may also include the undulations without the height.

## Description

### BACKGROUND

The present invention relates generally to microfluidic devices useful for chemical processing, and particularly to high-throughput pressure resistant microfluidic devices formed of structured consolidated frit defining recesses or passages between two or more substrates.

Microfluidic devices as herein understood are generally devices containing fluidic passages or chambers having typically at least one and generally more dimensions in the sub-millimeter to multiple millimeters range. Microfluidic devices can be useful to perform difficult, dangerous, or even otherwise impossible chemical reactions and processes in a safe, efficient, and environmentally-friendly way.

Microfluidic devices formed of structured consolidated frit defining recesses or passages in a volume between two or more substrates have been developed in previous work by the present inventors and/or their associates, as disclosed for example in U.S. Patent No. 6,769,444, "Microfluidic Device and Manufacture Thereof" and related patents or patent publications. Methods disclosed therein include various steps including providing a first substrate, providing a second substrate, forming a first frit structure on a facing surface of said first substrate, forming a second frit structure on a facing surface of said second substrate, and consolidating said first substrate and said second substrate and said first and second frit structures together, with facing surfaces toward each other, so as to form one or more consolidated-frit-defined recesses or passages between said first and second substrates.

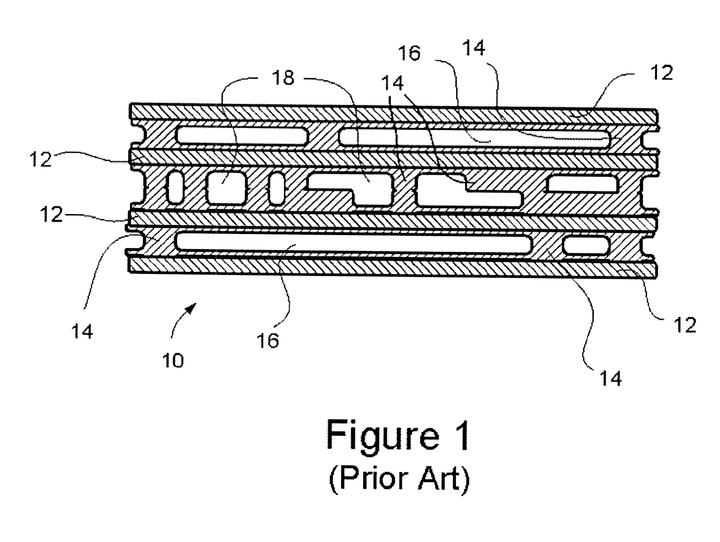

Figure 1 shows a cross-sectional schematic view of a microfluidic device 10 of this type. The microfluidic device 10 includes wall structures 14 formed of a consolidated frit material positioned between and joined to two or more spaced apart substrates 12 formed of a second material. The wall structures may preferably be formed of a consolidated glass or glass-ceramic frit. The substrates may be any desirable material compatible with the wall structures, and may preferably comprise glass, glass-ceramic, or ceramic. The wall structures 14 define fluidic passages, such as thermal reactant fluidic passages 18 for containing or mixing or otherwise processing flowable materials between the respective substrates 12, and/or such as control fluidic passages 16 for heat exchange fluid or the like.

In the process of making device 10 of Figure 1, varying frit structures may be formed on the various substrates of device 10. For example, for less complex fluidic passages such as passage 16, a pattern of frit walls may be formed on one substrate 12 while a thin flat layer of frit may be formed on the facing surface of the cooperating substrate 12. When the walls and thin layer are consolidated, such as by sintering, the wall structures 14 surrounding passage 16 are the result. For more complex fluidic passages such as passage 18, cooperating patterns of frit walls may be formed on facing surfaces of the substrates 12, such that consolidation together of the frit structures then forms the walls 14 surrounding the passage 18 of Figure 1.

In further work by the present inventors and/or their associates, high performance microreaction devices were developed, capable of a combination of good mixing at flow rates up to 150 ml/min at reasonable pressure drop, and having good thermal control, as shown for example in EPO patent application EP1679115, "High Performance Microreactor." Figure 2 is approximately 1:1 scale plan view of one layer of wall structure of an embodiment of one type of device corresponding to the device represented schematically in Figure 1, as disclosed in application EP16791155. The wall structures 14 assist in defining a fluidic passage 18 between two substrates that are not shown in the Figure. In this particular device, a non-three-dimensionally tortuous portion 17 of the passage 18 leads into a three-dimensionally tortuous portion 19 of the passage 18, in which the fluid flow is directed within the plane of the figure as well as in and out of the plane of the figure. Three-dimensionally tortuous portion 19 of the passage 18 leads in into a second non- three-dimensionally tortuous portion 21. For additional background on the particular applications and advantages of devices of the type of the structure of Figure 2, please see EPO patent application No. EP1679115.

While these previously disclosed devices and methods of manufacture are useful and produce well-performing devices of the types disclosed, it has become desirable to simultaneously optimize throughput capacity and pressure resistance, whether by increasing either one of these performance factors while minimizing any negative impact on the other, or by increasing both, relative to the previously disclosed devices.

### SUMMARY OF THE INVENTION

According to one alternative aspect of the invention, a microfluidic device, comprising wall structures formed of a consolidated frit material positioned between and joined to two or more spaced apart substrates formed of a second material, with the wall structures defining one or more fluidic passages between the substrates, has at least one passage with a height in a direction generally perpendicular to the substrates of greater than one millimeter, preferably greater than 1.1 mm, or than 1.2 mm, or than as much as 1.5 mm or more.

Another alternative aspect of the invention relates to a microfluidic device comprising consolidated glass or glass ceramic frit wall structures positioned between and joined to two or more spaced apart substrates with the wall structures defining one or more fluidic passages between the substrates, wherein, along a non-three-dimensionally tortuous portion of the one or more passages, the wall structures have an undulating shape such that no length of wall structure greater than 3 centimeters or greater than 2 centimeters, or greater than 1 centimeter, or even no length at all, is without a radius of curvature.

As yet another alternative aspect of the invention, both alternatives above may be combined, such that a microfluidic device of the type mentioned above desirably has at least one passage with a height of greater than 1 mm, or than 1.1 mm, or than 1.2 mm in height, up to as much as 1.5 mm or more, and that passage comprises a non- three-dimensionally tortuous portion defined by wall structures having an undulating shape, such that within that portion, no length of wall structure greater than 3 centimeters, or greater than 2 centimeters, or greater than 1 centimeter, or even no length at all, is without a radius of curvature.

Additional aspects of the invention will be set forth in the detailed description which follows, and in part will be readily apparent to those skilled in the art from that description or recognized by practicing the invention as described herein, including the detailed description which follows, the claims, as well as the appended drawings.

It is to be understood that both the foregoing general description and the following detailed description present embodiments of the invention, and are intended to provide an overview or framework for understanding the nature and character of the invention as it is claimed. The accompanying drawings are included to provide a further understanding of the invention, and are incorporated into and constitute a part of this specification. The drawings illustrate various embodiments of the invention and, together with the description, serve to explain the principles and operations of the invention.

### BRIEF DESCRIPTION OF THE DRAWINGS

Figure 1 is a schematic cross-sectional elevation view of a known type of microfluidic device.

Figure 2 is a cross-sectional plan view of a known embodiment of a microfluidic or microreaction device of the type of Figure 1.

Figures 3 is a perspective view of wall structures that may be used in conjunction with certain embodiments of the present invention.

Figure 4 is a cross-sectional view of a single fluidic passage useful for illustrating certain aspects of the present invention.

Figure 5 is a plan view of the wall structures of Figure 3.

Figures 6A-E are plan views of various wall structures, 6A of a known wall structure, and 6B through 6E showing some embodiments of one alternative aspect of the present invention.

Figure 7 is a cross-sectional plan view of microfluidic device similar to that of Figure 2 according to one alternative embodiment of the present invention.

### DETAILED DESCRIPTION OF THE PREFERRED EMBODIMENTS

Reference will now be made in detail to the present preferred embodiments of the invention, instances of which are illustrated in the accompanying drawings. Whenever possible, the same reference numerals will be used throughout the drawings to refer to the same or like parts.

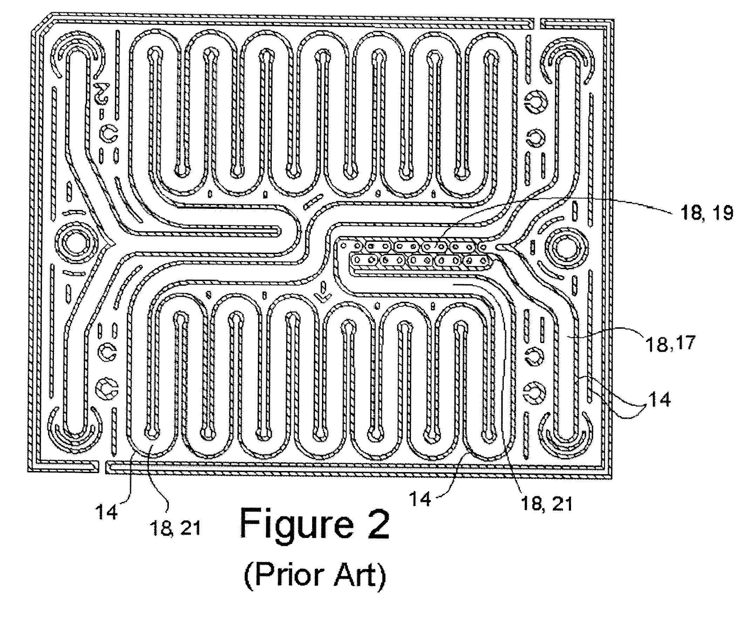

The present invention relates to microfluidic technology, particularly of the type discussed above in Figures 1 and 2.

Microreactors are one important class of microfluidic devices. Microreactors are microstructures used to perform reactions between chemical reactants by achieving mixing of the reactants and often by providing heat management. Usually, chemical reactants can be either gas or liquid. In many applications, liquid reactants are desirably driven through the microreactor by the mean of pumping systems. The typical flow rate of standard pumps is in the range of zero to typically 100 ml/min, or to even higher, such as a few liters per minute.

To provide useful production capability for multipurpose chemical plants (see, e.g., Multiproduct Plants, Wiley-VCH, 2003, Joachim Rauch, Ed.), inner volumes for the microreactors are preferably at least a few milliliters. In order to achieve such dimensions, in combination with good performance (linked to inner geometry), typical channel dimensions need to be larger than the classical hundreds of micrometers often used in the micro reaction technology field. Even with larger channels, flow rates of 100 ml/min and more can lead to significant pressure losses inside the structures and therefore to significant pressure within the microreactor at the entry point of the fluids.

In addition, for many applications, there is a need to conduct the reactions at a nominal pressure superior to atmospheric pressure (to keep low boiling point liquids in a liquid phase, or to counterbalance the effects of a temperature which approaches the boiling point, or to increasing the reaction kinetics, and so forth). Typical pressures for reactions conducted under pressure in liquid phase may be up to 10 bars, and can be more. For reactions involving gas phase, these pressures are typically significantly higher.

Whether because of high flow rates or because of the demands of the particular reaction(s), or by both, a microreactor may thus be required to be pressurized.

Microfluidic components can also be used to perform heat management of chemicals without initiating a reaction. Such components may also require improved pressure resistance because of needs of a particular reaction or because of a requirement of particularly high throughput.

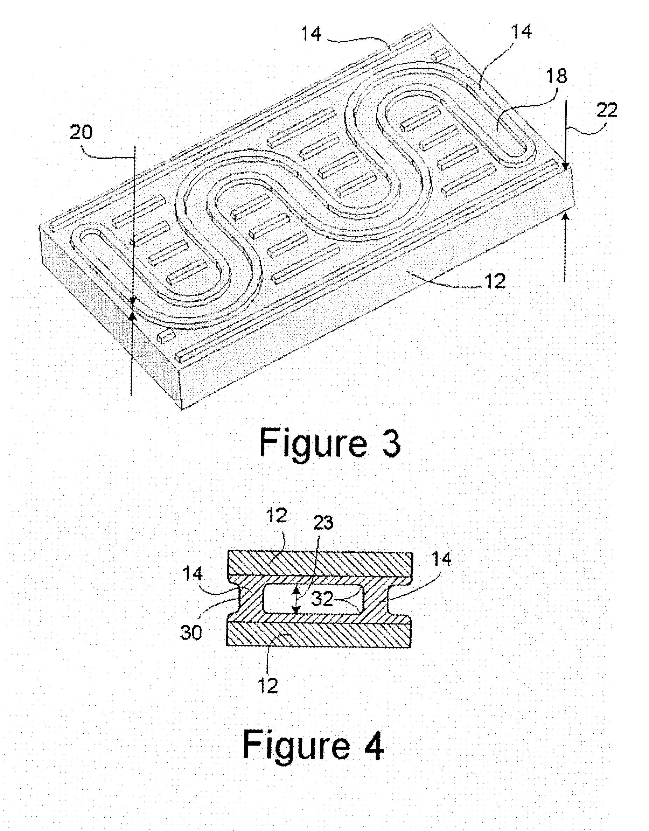

Figures 3 is a perspective view of wall structures of one embodiment of the present invention. The wall structures 14 are shown having a height 14 and disposed on a substrate 12 having a thickness 22, not shown to scale or even necessarily in relative scale. The wall structures 14 define the horizontal extent of a fluidic passage 18, but no upper substrate is shown in the Figure. The complete enclosure of fluidic passage 18 includes a substrate above the one shown, closing off passage 18 in the vertical direction in the figure. In the process of forming passage 18, wall structures 14 may be formed only on the substrate shown, or may be formed on both the substrate shown and on the substrate, not shown, that closes off passage 18 in the vertical direction. Forming complementary wall structures on the facing surfaces of two substrates can allow easier creation of taller passages.

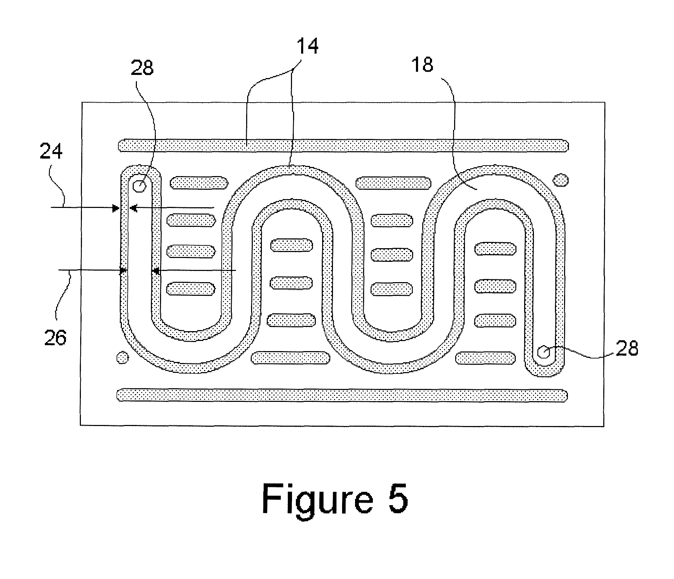

Figure 4 is a cross-sectional view of a single fluidic passage embodying one aspect of the present invention. Figure 5 is a plan view of the wall structures 14 and substrate 12 of Figure 3, showing the thickness 24 of the wall structures 14 and the width 26 of the passage(s) 18 defined thereby. Holes 28 are shown in substrate 12 whereby passage 18 may be accessed.

As may be appreciated and illustrated for ease of reference with respect to the cross-section of Figure 4, and the perspective view of Figure 3 and related plan view of Figure 5, one aspect of the structure of devices such as those shown in Figures 1 and 2 and of the preferred processes for making them is that the wall structures 14 are formed of a consolidated frit material and the substrates 12 are formed of a second, different material. Even where the chemical composition of the substrate and the wall structure 14 may be very close, the wall structures are formed of consolidated frit while the substrates are formed of individual pieces, preferably of glass, glass-ceramic, ceramic, or the like. Some portion of the wall structure is accordingly expected to be the site of any rupture failures when high relative internal pressures are present, and failure testing and failure analysis have borne this out. Accordingly, it was also believed that the height 20 of the wall structures 14 of Figure 3 should ideally be kept below some value such that the resulting passage height 23 of Figure 4 would be kept below some value, such as 300 or 400 µm, to prevent an excess of tensile stress from building up on the exterior center area 30 of the consolidated wall structures 14 as indicated in Figure 4. Even where throughput is to be maximized such as in a high performance microreactor such as that disclosed in EPO patent application No. EP 1679115 referenced above, it has been believed that passage height 23 should be within the range of 500 µm to 1 mm.

Surprisingly, simulation has shown and experiment has confirmed that when wall structures are insufficiently tall, pressure resistance of the microreactor or other microfluidic device of this type is actually lowered relatively to taller walls. This appears to be caused by a concentration of stress in the inside surface of the walls 14, where stress builds up in the inside corners 32. Where the inside corners are close to each other because the wall is sufficiently short, the areas of greatest stress are sufficiently close to cause an effective concentration of stresses in the wall structure. Simulation has shown that, for typical passage width 26 as shown in Figure 5 of anywhere from 2 to 5 mm, pressure capacity of the resulting microfluidic device increases by about 20% as the passage height 23 goes from 400 to 800 µm. More significantly, this increase is preserved at passage heights even beyond 1 mm, beyond 1.1 mm, and beyond 1.2 mm in height, up to as much as 1.5 mm or more. Taller walls or passages are of course also beneficial in that they decrease the inherent pressure drop of the microfluidic device, so that the overall effect on productivity is multiplicative: greater pressure capacity allows for higher flow rates absent any reduction in pressure drop; factoring in the reduced pressure drop allows still higher flow rates without generating enough inlet pressure to break the device. Accordingly, one alternative aspect of the present invention includes passages with heights greater than one millimeter within microfluidic devices of the type described above, greater than any previously employed wall heights in devices of this type. Preferably, the passage height 21 may be as much as 1.1 or 1.2 mm or more, or even 1.5 mm or more.

Wall widths 24 are preferably in the range of about 0.4 mm to 1.2 mm or more, with greater widths providing higher pressure capability. Increasing wall thickness, however, is not as effective as increasing wall height, and increased thickness can reduce the volume of the device, generally an undesirable change.

Passage widths 26 are preferably in the range of 2.5 mm to 5 mm or even 1 cm, and preferably in the range of 2 mm or less to 2.5 mm or less for higher pressure applications, as reducing passage width to these levels increases pressure capacity. Increasing wall height is preferable again, however, because increased wall height provides a larger gain in pressure resistance and because reduced passage width also decreases the device volume and increases pressure drop, thus reducing throughput at a given pressure.

Thus while increasing wall thickness and decreasing passage width both allow further increases in pressure resistance and may be used if desired, increasing wall or passage height is effective to simultaneously increase pressure resistance and throughput, and devices with increased passage height are accordingly one presently preferred alternative of the present invention.

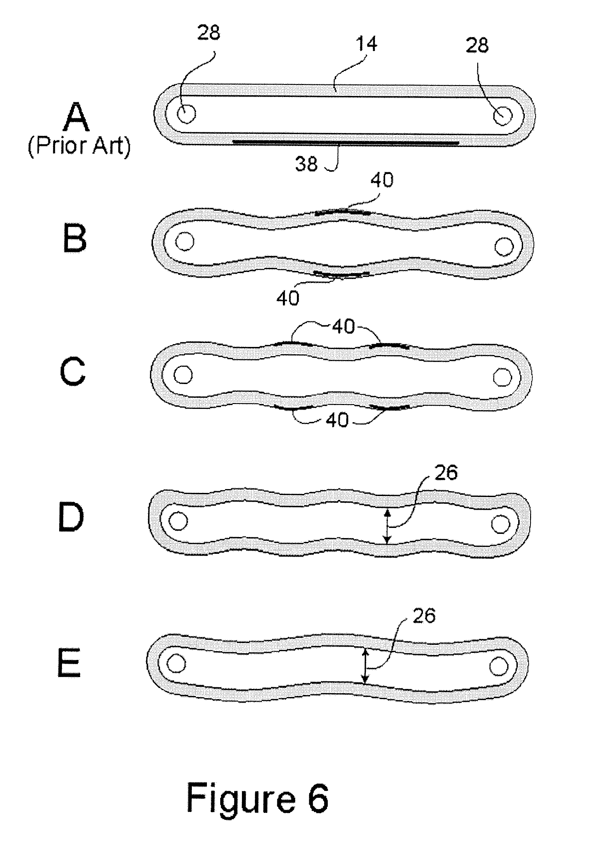

Figures 6A-E are plan views of wall structures 14 useful to illustrate a second alternative or additive embodiment of the present invention. Figure 6A shows a typical straight wall structure. Simulation has shown that tensile stress is at a maximum in an area 38 extending all along the straight portion of the walls 14. Accordingly, the present inventors have tested and simulated undulating walls of the types shown in Figures 6B-6E. Simulations and analysis have shown that maximum tensile stress is built up only in the outwardly bulging portions 40 of the undulating walls, such that much less of the wall material is at maximum tensile stress. Furthermore the maximum stress value tends to be slightly less for the undulating wall configuration relative to the typical straight walls of Figure 6A. Experiments have shown that pressure drop increases due to undulating walls are relatively slight, on the order of 20% increase at 100ml/min flow rate in one test, for example.

The undulations of the wall structures are desirably such that no length of wall equal to or greater than 3 cm is without a radius of curvature. The structure depicted in Figures 3 and 5, given appropriate dimensions such that the straight wall sections are less than 3 cm, fit this description. Preferably the wall structures undulate such that no length of wall equal to or greater than 2 cm is without a radius of curvature, and more preferably such that no length of wall equal to or greater than 1cm is without a radius of curvature, and most preferably such that no length of wall is without a radius of curvature, as in the alternative embodiments shown in Figures 6B-6E. Further, as shown in Figures 6D and 6E, the undulations are preferably arranged in parallel, such that the perpendicular width 26 of the passage is essentially constant, so that induced pressure drop is reduced relative to the configurations of Figures 6B and 6C.

The undulating wall structures may also optionally be applied in only a portion of a device, such as in the portions requiring greatest pressure resistance. For example, where a microfluidic device is to be fed by pumps and where the device itself has a portion with significant pressure drop, portions of the fluidic passage(s) upstream of the greatest pressure drop will be exposed to higher internal operating pressures than downstream portion. Accordingly, the undulating walls may be used only in the upstream portion if desired. Similarly, where a device is to be used with reactions that can generate significant pressures, the device may be designed for greatest pressure resistance wherever the greatest internal pressures occur, including at a reaction chamber or passage, for example.

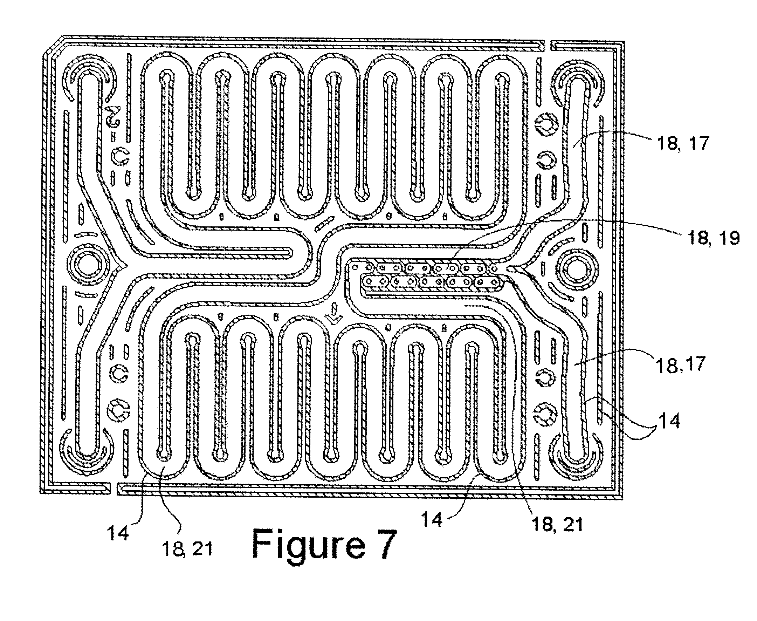

For a device such as that shown in Figure 2, for example, the undulating walls of this particular alternative aspect of the present invention may be applied in a non- three-dimensionally tortuous portion of the passage 18. This is shown in the embodiment of the present invention shown in cross-sectional plan view in Figure 7.

Because the non- three-dimensionally tortuous portion 17 the passage 18 is upstream of the three-dimensionally tortuous portion 19 of the passage 18, and because the device of Figure 7 is typically fed by a pump, the non- three-dimensionally tortuous portion 17 the passage 18 may be subject to the highest internal pressures of any location within the device. Accordingly, in the device of Figure 7, the non- three-dimensionally tortuous portion 17 of the passage 18 leads that into the three-dimensionally tortuous portion 19 of the passage 18 is defined by a corresponding portion the wall structures 14 having an undulating shape such that within said portion, no length of wall structure is without a radius of curvature. The non- three-dimensionally tortuous portion 21 of the passage 18 may experience less internal pressure, and is accordingly left with straight walls in this particular alternative embodiment of the present invention.

Of course for maximum benefit, a passage with passage heights of greater than 1 mm, or than 1.1 mm, or than 1.2 mm in height, up to as much as 1.5 mm or more may preferably be combined in the same microfluidic device together with a non- three-dimensionally tortuous portion of that passage, defined by corresponding wall structures having an undulating shape such that within that portion, no length of wall structure greater than 3 centimeters, or greater than 2 centimeters, or greater than 1 centimeter, or even no length at all, is without a radius of curvature. Thus the passage heights of the passages shown in Figure 7 are preferably greater than 1 mm, or than 1.1 mm, or than 1.2 mm in height, up to as much as 1.5 mm or more.

## Claims

1. A microfluidic device comprising wall structures formed of a consolidated frit material positioned between and joined to two or more spaced apart substrates formed of a second material, the wall structures defining one or more fluidic passages between the substrates, wherein at least one passage of said one or more fluidic passages has a height in a direction generally perpendicular to said substrates of greater than one millimeter.

2. The microfluidic device according to claim 1 wherein said consolidated frit material comprises one or more of a glass or a glass-ceramic.

3. The microfluidic device according to either of claims 1 and 2 wherein said second material comprises glass, glass-ceramic, or ceramic.

4. The microfluidic device according to any of claims 1-3 wherein a non- three-dimensionally tortuous portion of said at least one passage is defined by a corresponding portion of said wall structures having an undulating shape such that within said portion, no length of wall structure greater than 3 centimeters is without a radius of curvature.

5. The microfluidic device according to any of claims 1-3 wherein a non- three-dimensionally tortuous portion of said at least one passage is defined by a corresponding portion of said wall structures having an undulating shape such that within said portion, no length of wall structure greater than 2 centimeters is without a radius of curvature.

6. The microfluidic device according to any of claims 1-3 wherein a non- three-dimensionally tortuous portion of said at least one passage is defined by a corresponding portion of said wall structures having an undulating shape such that within said portion, no length of wall structure greater than 1 centimeter is without a radius of curvature.

7. The microfluidic device according to any of claims 1-3 wherein a non- three-dimensionally tortuous portion of said at least one passage is defined by a corresponding portion of said wall structures shaped such that, in a plane generally parallel to said substrates, there are no straight sections of said portion of said wall structures.

8. The microfluidic device according to any of claims 1-7 wherein a maximum width of said at least one passage does not exceed 7 mm.

9. The microfluidic device according to any of claims 1-7 wherein a maximum width of said at least one passage does not exceed 5 mm.

10. The microfluidic device according to any of claims 1-7 wherein a maximum width of said at least one passage does not exceed 2 mm.

11. The microfluidic device according to any of claims 4-7 wherein a maximum width of said non- three-dimensionally tortuous portion of said at least one passage does not exceed 7 mm.

12. The microfluidic device according to any of claims 4-7 wherein a maximum width of said non- three-dimensionally tortuous portion of said at least one passage does not exceed 5 mm.

13. The microfluidic device according to any of claims 4-7 wherein a maximum width of said non- three-dimensionally tortuous portion of said at least one passage does not exceed 2 mm.

14. A microfluidic device comprising consolidated glass or glass ceramic frit wall structures positioned between and joined to two or more spaced apart substrates, the wall structures defining one or more fluidic passages between the substrates, wherein, along a non- three-dimensionally tortuous portion of said one or more passages, the wall structures have an undulating shape such that no length of wall structure greater than 3 centimeters is without a radius of curvature in a plane parallel to the substrates.

15. The microfluidic device according to claim 14 wherein, along the non- three-dimensionally tortuous portion of said one or more passages, the wall structures have an undulating shape such that no length of wall structure greater than 2 centimeters is without a radius of curvature in a plane parallel to the substrates.

16. The microfluidic device according to claim 14 wherein, along the non- three-dimensionally tortuous portion of said one or more passages, the wall structures have an undulating shape such that no length of wall structure greater than 1 centimeter is without a radius of curvature in a plane parallel to the substrates.

17. The microfluidic device according to claim 14 wherein, along the non- three-dimensionally tortuous portion of said one or more passages, the wall structures have an undulating shape such that no length of wall structure is without a radius of curvature in a plane parallel to the substrates.
